# EUROPÄISCHE PATENTSCHRIFT

(11) **EP 1 114 461 B1**
(45) Veröffentlichungstag und Bekanntmachung des Hinweises auf die Patenterteilung: **27.12.2006**
(21) Anmeldenummer: 99969181.9
(22) Anmeldetag: 07.09.1999
(51) Int. Cl.: H01L 27/092

(54) **HALBLEITER-SCHALTUNGSANORDNUNG**
SEMICONDUCTOR CIRCUIT
CIRCUIT A SEMICONDUCTEUR

(30) Priorität: 10.09.1998 DE 19841445
(43) Veröffentlichungstag der Anmeldung: 11.07.2001
(73) Patentinhaber: Qimonda AG, 81739 München (DE)
(72) Erfinder: HOFFMANN, Kurt, D-82024 Taufkirchen (DE); KOWARIK, Oskar, D-85579 Neubiberg (DE); HÖNIGSCHMID, Heinz, D-82319 Starnberg (DE); BRAUN, Georg, D-80339 München (DE)
(74) Vertreter: Kottmann, Heinz Dieter
(86) Internationale Anmeldenummer: PCT/DE1999/002831
(87) Internationale Veröffentlichungsnummer: WO 2000/016399

(56) Entgegenhaltungen:
- EP-A- 0 522 579
- EP-A- 0 559 995
- EP-A- 0 649 146
- EP-A- 0 801 396
- DE-A- 19 706 537
- US-A- 5 602 797

## Beschreibung

Die Erfindung bezieht sich auf eine Halbleiter-Schaltungsanordnung mit einer in einem Halbleitersubstrat eines ersten Leitfähigkeitstyps integriert ausgebildeten Treiberschaltung bestehend aus PV-Schalttransistoren zum Schalten von positiven und/oder nullwertigen Spannungspegeln und NV-Schalttransistoren zum Schalten von negativen und/oder nullwertigen Spannungspegeln, und einer der Treiberschaltung vorgeschalteten, gleichfalls im Halbleitersubstrat ausgebildeten Ansteuerschaltung, wobei das Halbleitersubstrat an einen Substratpegel angeschlossen ist. Die Erfindung bezieht sich ferner auf eine Halbleiter-Schaltung mit ein Invertierungs- und Pegelverschiebungsschaltung.

Halbleiter-Schaltungsanordnungen bzw. -Schaltungen der gattungsgemäßen Art finden insbesondere als Wortleitungsdekoder bei elektrisch löschbaren Nurlesespeichern Anwendung. Die vorbekannten Wortleitungsdekoder können gleichzeitig immer nur zwei Spannungen an ein nachfolgendes Zellfeld anlegen, so schaltet zum Beispiel bei EEPROMs der Dekoder beim Lesen zwischen Null und beispielsweise +2,5 Volt oder beim Programmieren zwischen Null Volt und der Programmierspannung VPP (z.B. -12 Volt). Unter bestimmten Bedingungen kann es wünschenswert sein, mit einem Wortleitungsdekoder gleichzeitig verschiedene Signalleitungen (Wortleitungen) mit entweder einem Nullpegel für nicht ausgewählte Leitungen, einer positiven Spannung VH (z.B. der Versorgungsspannung) und einer negativen Spannung - VB für ausgewählte komplementäre Leitungspaare zu beaufschlagen. Ein Beispiel hierfür ist die Ansteuerung der Wortleitungen in einem Zellfeld mit ferroelektrischen Zellen.

Aus der EP 0 522 579 A1 ist eine Treiber-Schaltung für EEPROM-Speiser bekannt geworden, bei der sog."floating gate" Transistoren zum Einsatz kommen, bei denen vermittels eines "source-column"-Dekoders alle Source- bzw. Drain- Anschlüsse aller Transistoren einer gesamten Spalte des Speicherzellenarrays gleichzeitig aufgeschaltet werden. Die in der Zeilenauswahlschaltung ausgebildete Treiber-Schaltung wird zur gleichzeitigen Auswahl aller Transistoren einer Zeile des Speicherzellenarrays verwendet. Hierbei ist ein negative Spannungen schaltender Transistor in einer zusätzlichen Wanne ausgebildet.

Der Erfindung liegt die Aufgabe zugrunde, eine Halbleiter-Schaltungsanordnung, insbesondere eine Dekoderschaltung zur Verfügung zu stellen, die gleichzeitig einen Nullpegel, eine positive und eine negative Spannung treiben kann.

Die Aufgabe wird durch eine Halbleiter-Schaltungsanordnung nach Anspruch 1 gelöst.

Erfindungsgemäß ist vorgesehen, dass die Treiberschaltung aus mehreren Schaltungsstufen besteht, und die erste Stufe der Treiberschaltung eine erste Invertierungs- und Pegelverschiebungsschaltung aufweist, wobei der NV-Schalttransistor der Treiberschaltung innerhalb einer in dem Halbleitersubstrat eingebetteten äußeren Wanne eines zweiten, gegenüber dem ersten Leitfähigkeitstyp entgegengesetzten Leitfähigkeitstyps ausgebildet ist, und die äußere Wanne an eine Versorgungsspannung angeschlossen ist.

Bei Verwendung von herkömmlicher CMOS-Technologie treten beim Schalten negativer Spannungen bei den NMOS-Transistoren parasitäre Dioden auf, durch die Leckströme auftreten. Die Erfindung schlägt daher vor, den der Ansteuerschaltung nachgeschalteten Treiber oder mindestens Schaltungsgruppen oder Transistoren des ebensolchen in eine wenigstens bereichsweise ausgebildete äußere Wanne zu verlegen. Diese Wanne ist dabei von gegenüber dem Leitfähigkeitstyp des Substrats entgegengesetztem Leitfähigkeitstyp und an die Versorgungsspannung angeschlossen. Der Vorteil dieser Halbleiter-Schaltungsanordnung liegt darin, dass die parasitären Dioden der in der äußeren Wanne eingebetteten NMOS-Transistoren nun nicht mehr leitend werden können. Dadurch kann sich die an die Wanne der NMOS-Transistoren angelegte zu schaltende negative Spannung nicht mehr nachteilig auf die restliche auf dem Substrat befindliche Schaltung auswirken.

In einer besonders bevorzugten Ausführung der Erfindung ist die Ansteuerschaltung durch einen Dekoder mit mehreren an die Treiberschaltung gekoppelten Ausgängen ausgebildet. Weiterhin von Vorteil ist, dass der aktiv geschaltete Ausgang des Dekoders einen Nullpegel, alle übrigen, passiv geschalteten Ausgänge dabei jeweils einen positiven Potentialpegel liefern.

Erfindungsgemäß sind die Ausgänge der Treiberschaltung durch mindestens ein Aktivierungsleitungspaar gebildet. Diese aus komplementären Einzelleitungen aufgebauten Aktivierungsleitungspaare tragen dann auf beiden Leitungen einen Nullpegel oder im aktiven Zustand positive und negative Aktivierungsspannungen, die durch der ersten Invertierungs- und Pegelverschiebungsschaltung nachgeschalteten Aktivierungsschalter auf die Aktivierungsleitungspaare aufgeschaltet werden. Der Erfindung folgend können auch mehrere Aktivierungsleitungspaare gleichzeitig auf die positiven und negativen Aktivierungsspannungen aufgeschaltet werden. Dabei kann durch eine den Aktivierungsschaltern vorgeschaltete Auswahlschaltung, die durchzuschaltende Aktivierungsspannungen festlegt, die Polarität der Potenziale der komplementären Leitungen vertauscht werden.

Vorteilhafterweise kann das Potenzial der positiven Aktivierungsspannung auch über dem Potenzial der Versorgungsspannung liegen. Dem folgend ist es von Vorteil, dass der ersten Invertierungs- und Pegelverschiebungssehaltung und den Aktivierungsschaltern, die die positive und negative Aktivierungsspannung auf die Aktivierungsleitungspaare aufschalten, jeweils ein Sicherungstransistor vordefinierter Leitfähigkeit (NMOS) zwischengeschaltet ist, der mit seinem Steueranschluss an der Versorgungsspannung angeschlossen ist, und mit einem Elektrodenanschluss mit der ersten Invertierungs- und Pegelverschiebungsschaltung, und mit dem anderen Elektrodenanschluss mit den Steueranschlüssen der Aktivierungsschalter verbunden ist.

Bei einer weiteren vorteilhaften Ausbildung der Erfindung ist der ersten Invertierungs- und Pegelverschiebungsschaltung eine zweite Invertierungs- und Pegelverschiebungsschaltung nachgeschaltet, die mit den Steueranschlüssen zweier Deaktivierungsschalter verbunden ist, die die Aktivierungsleitungen auf den Substratpegel schalten. Auch hier ist es möglich, mehrere gepaarte komplementäre Leitungen gleichzeitig zu schalten.

In einer bevorzugten Ausführung der Erfindung kann vorgesehen sein, dass der ersten Invertierungs- und Pegelverschiebungsschaltung ein Haltetransistor, beispielsweise durch einen MOS-Transistor vom positiven Leitungstyp, zugeordnet ist, der mit seinem Steuereingang mit dem Ausgang des ersten Invertierungs- und Pegelverschiebungsschaltung und mit seinen Elektrodenanschlüssen zum Einen mit der Versorgungsspannung, und zum Anderen mit dem Eingang der Invertierungs- und Pegelverschiebungsschaltung verbunden ist. Der Vorteil des Haltetransistors ist, dass er den High-Pegel am Eingang unterstützt, und so ein Standard-1-aus-2^{N}-NAND-Dekoder zum Einsatz kommen kann.

Eine weitere Ausgestaltung der Erfindung sieht vor, dass wenigstens eine der Invertierungs- und Pegelverschiebungsschaltungsanordnungen mit zwei Transistoren entgegengesetzter Polarität vorgesehen ist. Diese sind im Halbleitersubstrat eines ersten Leitfähigkeitstyps integriert, wobei mindestens der Transistor vom negativen Typ innerhalb einer in dem Halbleitersubstrat eingebetteten äußeren Wanne eines gegenüber dem Leitfähigkeitstyp des ersten Halbleitersubstrats entgegengesetzten Leitfähigkeitstyp ausgebildet ist, und die äußere Wanne an die Versorgungsspannung angeschlossen ist. Ferner besitzt die Schaltung einen Signaleingang, der mit den Steuereingängen der Transistoren entgegengesetzter Polarität verbunden ist und einen Signalausgang, der mit jeweils einem Elektrodenanschluss der Transistoren verbunden ist. Die beiden verbleibenden Elektrodenanschlüsse der Transistoren entgegengesetzter Polarität sind zum Einen beim positiven Typ mit der positiven Versorgungsspannung, und beim negativen Typ mit einer negativen Spannung verbunden.

Weiterhin vorteilhaft ist, dass wenigstens eine der Invertierungs- und Pegelverschiebungsschaltungsanordnungen, die in einem Halbleitersubstrat eines ersten Leitfähigkeitstyps ausgebildet ist, mit einem Signaleingang, der mit dem Steuereingang eines ersten Transistors vom negativen Typ verbunden ist, dessen eine Elektrode mit der negativen Versorgungsspannung, und dessen andere Elektrode mit dem Signalausgang der Schaltungsanordnung verbunden ist. Mit dem Signalausgang ist zudem eine Elektrode eines Transistors vom positiven Typ verbunden, dessen andere Elektrode mit einer positiven Versorgungsspannung und dessen Steuereingang mit dem Signaleingang der Schaltungsanordnung verbunden ist. Am Signaleingang ist weiterhin eine Elektrode eines weiteren Transistors vom negativen Typ angeschlossen, dessen andere Elektrode mit der negativen Versorgungsspannung, und dessen Steuereingang mit dem Signalausgang verbunden ist. Dabei sind die Transistoren vom negativen Typ innerhalb einer in dem Halbleitersubstrat eingebetteten äußeren Wanne eines zweiten, gegenüber dem Typ des Halbleitersubstrats entgegengesetzten Leitfähigkeitstyp ausgebildet. Zweckmäßigerweise ist diese äußere Wanne an eine Versorgungsspannung angeschlossen.

Dem Prinzip der Erfindung folgend ist dem Signaleingang der Invertierungs- und Pegelverschiebungsschaltung ein Transistor positiven Typs vorgeschaltet, dessen Steuereingang mit einem Nullpotential verbunden ist, und dessen Elektrodenanschlüsse zum Einen mit dem Eingangssignal, und zum Anderen mit dem Signaleingang der Invertierungs- und Pegelverschiebungsschaltung verbunden ist.

Zweckmäßige Weiterbildungen der Erfindung ergeben sich aus den Unteransprüchen.

Nachfolgend wird die Erfindung anhand-mehrerer in der Zeichnung dargestellter Ausführungsbeispiele weiter erläutert. Es zeigt:
- Figur 1: eine schematische Schnittansicht einer in einem Substrat ausgebildeten Halbleiterstruktur;
- Figur 2: einen schematischen Schaltplan einer Halbleiter-Schaltungsanordnung nach einem ersten Ausführungsbeispiel der Erfindung;
- Figur 3: einen schematischen Schaltplan einer Halbleiter-Schaltungsanordnung nach einem zweiten Ausführungsbeispiel der Erfindung;
- Figur 4: einen schematischen Schaltplan einer Halbleiter-Schaltung nach einer weiteren Ausführungsform der Erfindung; und
- Figur 5: einen schematischen Schaltplan einer Halbleiter-Schaltung nach einer weiteren Ausführungsform der Erfindung.

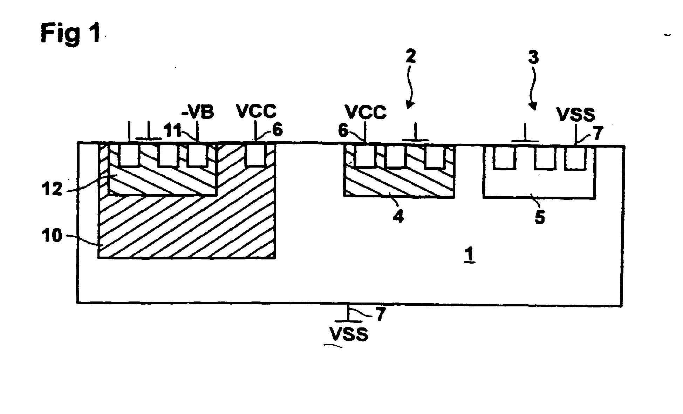

Der in Figur 1 gezeigte Schnitt durch eine Halbleiterstruktur zeigt in einem p-leitenden Substrat 1 ausgebildete PV- und NV-Schalttransistoren 2 und 3, wobei die PV-Schalttransistoren 2 eine n-leitende, in das Substrat eingebrachte Wanne 4, die an die Versorgungsspannung 6 angeschlossen ist, und die NV-Schalttransistoren 3 eine p-leitende, in das Substrat eingebrachte Wanne 5, die an den Substratpegel 7 angeschlossen ist, aufweisen. Ein NV-Schalttransistor 12, zum Schalten negativer Schaltspannungen 11, ist in einer zusätzlichen äußeren Wanne 10 ausgebildet, deren Leitfähigkeitstyp dem des Substrats 1 gegenüber entgegengesetzt ist. Diese äußere Wanne 10 ist mit der Versorgungsspannung 6 verbunden. Dadurch wird verhindert, dass zwischen Potenzial 11 ( ∼ VB).und Substratanschluss (VSS) ein Strom fließt.

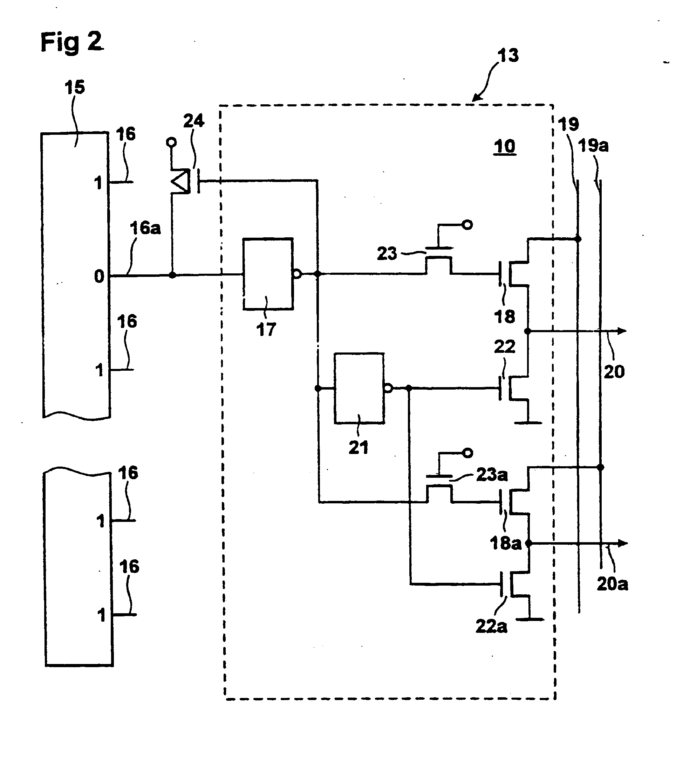

Figur 2 zeigt ein schematisches Schaltbild eines erfindungsgemäßen Wortleitungsdekoders. Einer Ansteuerschaltung in Form eines Standard-1-aus-2^{N}-NAND-Dekoder mit Ausgängen 16 und 16a ist eine Treiberschaltung 13 nachgeschaltet. Den Ausgängen 16 und hier im Beispiel dem aktiven Ausgang 16a ist ein Inverter 17 nachgeschaltet, der zusätzlich eine Pegelverschiebung seines Eingangssignals durchführt. Der Inverter 17 schaltet über Aktivierungsschalter 18 und 18a die an den Leitungen 19 und 19a anliegenden Aktivierungsspannungen auf ein komplementär ausgebildetes Aktivierungsleitungspaar 20 und 20a auf. Die Neutralschaltung des Aktivierungsleitungspaares auf einen Nullpegel wird durch einen weiteren Inverter 21 mit Pegelverschiebung gewährleistet, der dem ersten Inverter 17 nachgeschaltet ist, und dem zwei Deaktivierungsschalter 22 und 22a nachgeschaltet sind, welche den Substratpegel auf das Aktivierungsleitungspaar 20 und 20a aufschalten, wenn der Ausgang 16a des Dekoders 15 passiv ("high") geschaltet ist. Dem ersten Inverter 17 und den Aktivierungsschaltern 18 und 18a sind Sicherungstransistoren 23 und 23a zwischengeschaltet, deren Steueranschlüsse an der Versorgungsspannung liegen, und deren Elektroden jeweils mit dem Inverter und dem Aktivierungsschalter verbunden sind. Diese Sicherungstransistoren gewährleisten das bei Anlegen einer gegenüber der Versorgungsspannung erhöhten Spannung an der Leitung 19 bzw. 19a, ohne dass dies Rückwirkungen auf die davor liegende Schaltung hat. Um eine unnötige Belastung der Ausgänge 16 und 16a des NAND-Dekoders 15 zu verhindern, ist dem ersten Inverter 17 ein Haltetransistor 24 (beispielsweise PMOS-Transistor) vorgeschaltet, dessen Steuereingang mit dem Ausgang des Inverters 17, dessen eine Elektrode am Eingang des Inverters 17 und dessen andere Elektrode mit der Versorgungsspannung verbunden ist. Erfindungsgemäßerweise wird der gesamte Schaltungsteil des dem Dekoder 15 nachgeschalteten Treibers 13 in eine im Substrat 1 ausgebildete äußere Wanne 10 eingebettet, damit die Schaltvorgänge der negativen und positiven Aktivierungsspannungen, die an den Leitungen 19 und 19a anliegen, nicht negativ auf den auf dem gleichen Substrat ausgebildeten Dekoder 15 oder andere Schaltungsteile durch Verschiebung der Arbeitspunkte der Transistoren, oder Leckströme innerhalb der ebensolchen, einwirken kann. Hierzu ist die äußere Wanne 10 mit der Versorgungsspannung verbunden. Das ausgangsseitige komplementäre Aktivierungsleitungspaar 20 und 20a, kann durch die erfindungsgemäße Lehre mit jeweils einer positiven und negativen Spannung oder mit dem Nullpegel beaufschlagt werden.

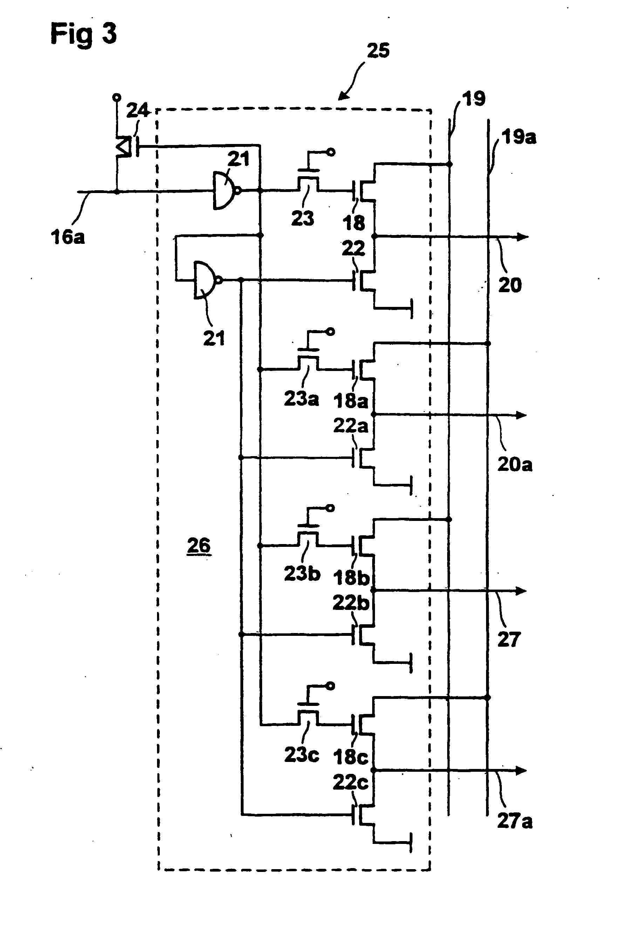

Figur 3 zeigt einen Schaltungsvorschlag, bei dem ein zweites Aktivierungsleitungspaar 27 und 27a mit Aktivierungsschaltern (18b und 18c), Deaktivierungsschaltern (22b und 22c) und Sicherungstransistoren (23b und 23c), zusätzlich zum ersten (20 und 20a) getrieben wird. Dabei ist die gesamte Treiberschaltung 25, innerhalb einer äußeren Wanne 26 ausgebildet, die mit der Versorgungsspannung verbunden ist. Diesem Gedanken folgend können mehr als zwei Aktivierungsleitungspaare vorgesehen sein.

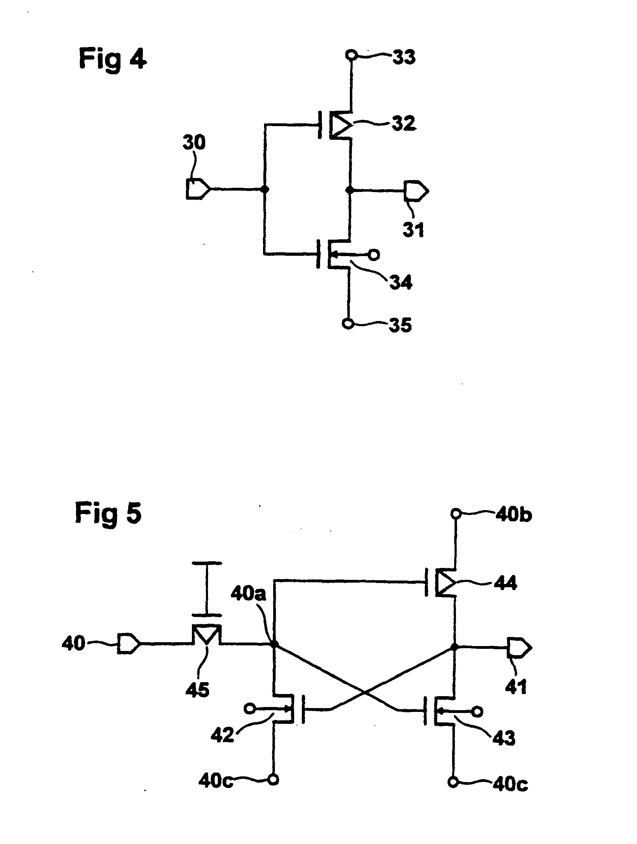

Figur 4 zeigt eine erfindungsgemäße Invertierungs- und Pegelverschiebungsschaltungsanordnung, die über einen Eingang 30, einen Ausgang 31 und über ein Transistorpaar mit entgegengesetzten Polaritäten verfügt, wobei der Transistor vom positiven Leitungstyp 32 mit seiner einen Elektrode mit der Versorgungsspannung 33, und mit seiner anderen Elektrode mit dem Ausgang 31 und mit seinem Steuereingang mit dem Eingang 30 verbunden ist. Der Transistor vom negativen Leitungstyp 34 ist mit einer negativen Versorgungsspannung 35 an der einen Elektrode, mit seinem Steuereingang mit dem Eingang 40 und mit seiner anderen Elektrode am Ausgang 31 der Schaltungsanordnung verbunden.

In dem Halbleitersubstrat ist eine mindestens den Transistor 34 zum Schalten der negativen Versorgungsspannung beinhaltende äußere Wanne vorgesehen, deren Polaritätstyp dem des Substrats entgegengesetzt ist. Erfindungsgemäß wird durch die Schaltungsanordnung der am Eingang 30 anliegende Pegel, der Null oder einen positiven Wert hat, invertiert und pegelverschoben. Im Falle eines positiven Wertes des Eingangssignals wird das Signal auf den Wert der negativen Versorgungsspannung, und im Falle eines Nullpegels auf den Wert der positiven Versorgungsspannung verschoben.

Figur 5 zeigt eine weitere Ausgestaltung einer Invertierungs-und Pegelverschiebungsschaltungsanordnung, bei der die gesamte Schaltung innerhalb eines Substrats ausgebildet ist, und wenigstens die beiden Transistoren vom negativen Typ 42 und 43 innerhalb einer äußeren Wanne von einem Leitungstyp entgegengesetzt dem Substrattyp ausgebildet sind. Dem Eingang 40a der Schaltungsanordnung sind zwei Transistoren 42 und 43 negativen Typs zugeordnet, die mit jeweils einer ihrer Elektroden mit der negativen Versorgungsspannung verbunden sind. Die andere Elektrode der Transistors 43 ist mit dem Signaleingang, die des Transistors 42 oder Signalausgang verbunden. Der Steuereingang des eingangsseitigen negativen Transistors 42 ist dabei mit dem Signalausgang 41, und der Steuereingang des ausgangsseitigen negativen Transistors 43 mit dem Eingang 40a verbunden. Ein Transistor 44 positiven Typs ist mit seiner einen Elektrode mit der positiven Versorgungsspannung und mit seiner anderen Elektrode mit dem Ausgang 41 der Schaltungsanordnung verbunden. Der Steuereingang des Transistors 44 ist dabei mit dem Eingang 40a verbunden. Vor dem Eingang der Invertierungs- Pegelverschiebungsstufe ist dabei ein PMOS-Transistor 45 vorgesehen, der verhindert, dass die negative Versorgungsspannung der Schaltungsanordnung auf den Signaleingang 40 übertragen werden kann. Er ist daher mit seinem Steuereingang am Nullpegel angeschlossen.

In dem die Schaltung beinhalten Substrat ist eine mindestens die Transistoren 42 und 43 zum Schalten der negativen Versor-gungsspannung beinhaltende äußere Wanne vorgesehen, deren Polaritätstyp dem des Substrats entgegengesetzt ist. Erfindungsgemäß wird durch die Schaltungsanordnung der am Eingang 40 anliegende Pegel, der Null oder einen positiven Wert hat, invertiert und pegelverschoben. Im Falle eines positiven Wertes des Eingangssignals wird das Signal auf den Wert der negativen Versorgungsspannung, und im Falle eines Nullpegels auf den Wert der positiven Versorgungsspannung verschoben.

## Patentansprüche

1. Halbleiter-Schaltungsanordnung mit einer in einem Halbleitersubstrat (1) eines ersten Leitfähigkeitstyps integriert ausgebildeten Treiberschaltung (13) bestehend aus einem ersten und einem zweiten PV-Schalttranststor (18. 22a) zum Schalten von positiven und nullwertigen Spannungspegeln und aus einem ersten und einem zweiten NV-Schalttransistor (22. 18a) zum Schalten von negativen und nullwertigen Spannungspegeln. und einer der Treiberschaltung (13) vorgeschalteten, gleichfalls im Halbleitersubstrat (1) ausgebildeten Ansteuerschaltung, wobei:
- das Halbleitersubstrat (1) an einen Substratpegel angeschlossen ist,
- die Treiberschaltung (13) aus mehreren Schaltungsstufen besteht, und die erste Stufe der Treiberschaltung eine erste Invertierungs- und Pegelverschiebungsschaltung (17) aufweist,
- die Ausgänge der Treiberschaltung (13) durch mindestens ein Aktivterungsleitungspaar, bestehend aus komplementären Einzelleitungen (20 und 20a), ausgebildet sind
- der erste PV-Schalttransistor (18) zwischen eine erste Leitung (19) und eine erste Einzelleitung (20) geschaltet ist.
- der erste NV-Schalttransistor (22) zwischen den Substratpegel und die erste Einzelleitung (20) geschaltet ist,
- der zweite NV-Schalttransistor (18a) zwischen eine zweite Leitung (19a) und eine zweite Einzelleitung (20a) geschaltet ist,
- der zweite PV-Schalttransistor (22a) zwischen den Substratpegel und die zweite Einzelleitung (20a) geschaltet ist, und
- der erste PV- und erste NV-Schalttransistor (18, 22) die an der ersten Leitung (19) anliegende Aktivierungsspannung auf die erste Einzelleitung (20) aufschalten, wobei gleichzeitig der zweite PV- und zweite NV-Schalttransistor die an der zweiten Leitung (19a) anliegende Aktivierungsspannung auf die zweite Einzelleitung (20a) aufschalten, oder die jeweiligen Transistoren beide Einzelleitungen (20. 20a) auf Substratpegel schalten.
wobei
- die NV-Schalttransistoren (22, 18a) der Treiberschaltung (13) innerhalb einer in dem Halbleitersubstrat (1) eingebetteten äußeren Wanne (10) eines zweiten, gegenüber dem ersten Leitfähigkeitstyp entgegengesetzten Leitfähigkeitstyps ausgebildet sind.
- die äußere Wanne (10) an eine Versorgungsspannung angeschlossen ist, und
- beide Aktivierungsspannungen von entgegengesetzter Polarität sein können.

2. Halbreiter-Schaltungsanordnung nach Anspruch 1, **dadurch gekennzeichnet, daß** die Ansteuerschaltung durch einen Dekoder (15) mit mehreren an die Treiberschaltung (13) gekoppelten Ausgängen (16 und 16a) ausgebildet ist.

3. Halbleiter-Schaltungsanordnung nach Anspruch 2, **dadurch gekennzeichnet, daß** ein aktiv geschalteter Ausgang (16a) des Dekoders (15) einen Nullpegel, alle übrigen, passiv geschalteten Ausgänge des Dekoders jeweils einen positiven Potentialpegel liefern.

4. Halbleiter-Schaltungsanordnung nach Anspruch 3, **dadurch gekennzeichnet, daß** der ersten Invertierungs- und Pegelverschiebungsschaltung (17) der erste PV-Schalttransistor (18) und der zweite NV-Schalttransistor (18a) nachgeschaltet sind, die jeweils eine an der Treiberschaltung (13) anliegende negative Aktivierungsspannung (19) auf mindestens die erste Einzelleitung (20) des Aktivierungsleitungspaares (20 und 20a), und eine ebenfalls an der Treiberschaltung anliegende positive Aktivierungsspannung (19a) auf die zweite Einzelleitung des mindestens einen Aktivierungsleitungspaares durchschalten.

5. Halbleiter-Schaltungsanordnung nach Anspruch 4, **dadurch gekennzeichnet, daß** das Potential der positiven Aktivierungsspannung (19) gleich oder über dem Potential der Versorgungsspannung liegt.

6. Halbleiter-Schaltungsanordnung nach Anspruch 5, **dadurch gekennzeichnet, daß** der ersten Invertierungs- und Pegelverschiebungsschaltung {17} eine zweite Invertierungs- und Pegelverschiebungsschaltung (21) nachgeschaltet ist, die mit den Steueranschlüssen des ersten NV-Schalttransistors (22) und des zweiten PV-Schalttransistors (22a) (22 und 22a) verbunden ist, deren Elektrodenanschlüsse zum einen mit dem Substratpegel und zum anderen mit den beiden komplementären Einzelleitungen (20 und 20a) des mindestens einen Aktiverungsleitungspaares verbunden sind.

7. Halbleiter-Schaltungsanordnung nach Anspruch 6. **dadurch gekennzeichnet, daß** der ersten Invertierungs- und Pegelverschiebungsschaltung (17) und dem ersten PV-Schalttransistor (18) sowie dem zweiten NV-Schalttransistor (18a), die die positive und negative Aktivierungsspannung (19 und 19a) schalten, jeweils ein Sicherungstransistor (23 und 23a) vordefinierter Leitfähigkeit (NMOS) zwischengeschaltet ist, der mit seinem Steueranschluss an der Versorgungsspannung und mit seinem Elektrodenanschlüssen zum einen mit der ersten Invertierungs- und Pegelverschiebungsschaltung und zum anderen mit dem ersten PV-Schalttransistor (18) und dem zweiten NV-Schalttransistor (18a) verbunden ist.

8. Halbleiter-Schaltungsanordnung nach Anspruch 7. **dadurch gekennzeichnet, daß** ein Haltetransistor (24) vorhanden ist, der mit seinem Steuereingang mit dem Ausgang der ersten Invertierungs- und Pegelverschiebungsschaltung (17), und mit seinen Elektrodenanschlüssen zum einen mit der Versorgungsspannung und zum anderen mit dem Eingang der ersten Invertierungs- und Pegelverschiebungsschaltung (17) verbunden ist.

9. Halbleiter-Schaltungsanordnung nach Anspruch 8, **dadurch gekennzeichnet, daß** der Haltetransistor (24) durch einen MOS-Transistor vom positiven Leitungstyp ausgebildet ist

10. Halbleiter-Schaltungsanordnung nach einem der Ansprüche 6 bis 9, **dadurch gekennzeichnet, daß** die erste und zweite Invertierungs- und Pegelverschiebungsschaltung (17 und 21), die Sicherungstransistoren (23 und 23a), der erste PV-Schalttransistor (18) sowie der zweite NV-Schalttransistor (18a) und der erste NV-Schalttransistor (22) und der zweite PV-Schalttransistor (22a) (22, 22a) innerhalb der äußeren Wanne (10) des Halbleitersubstrats eingebettet sind.

11. Halbleiter-Schaltungsanordnung nach Anspruch 10, **dadurch gekennzeichnet, daß** der Haltetransistor (24) innerhalb der äußeren Wanne eingebettet ist.

12. Halbleiter-Schaltungsanordnung nach einem der Ansprüche 3 bis 11, **dadurch gekennzeichnet, daß** wenigstens eine der Invertierungs- und Pegelverschiebungsschaltungen durch zwei in dem Halbleitersubstrat (1) eines ersten Leitfähigkeitstyps integrierte Transistoren entgegengesetzter Polarität (32 und 34) ausgebildet ist und einen Signaleingang (30) und einen Signalausgang (31) aufweist, wobei das Halbleitersubstrat (1) an den Substratpegel angeschlossen ist.

13. Halbleiter-Schaltungsanordnung nach Anspruch 12, **dadurch gekennzeichnet, daß** die Steuereingänge der Transistoren mit dem Signaleingang (30) verbunden sind, wobei der Transistor positiven Typs (32) mit seiner einen Elektrode mit einer positiven Versorgungsspannung (33) und mit der anderen Elektrode mit dem Ausgang (31) verbunden ist, und der Transistor negativen Typs (34) mit der einen Elektrode am Ausgang (31) und mit der anderen Elektrode mit einer negativen Spannung (35) verbunden ist, und daß der Transistor vom negativen Typ (34) innerhalb einer in dem Halbleitersubstrat (1) eingebetteten äußeren Wanne eines zweiten, gegenüber dem ersten Leitfähigkeitstyp entgegengesetzten Leitfähigkeitstyps ausgebildet ist, und die äußere Wanne an eine Versorgungsspannung angeschlossen ist.

14. Halbleiter-Schaltungsanordnung nach einem der Ansprüche 3 bis 13, **dadurch gekennzeichnet, daß** wenigstens eine der Invertierungs- und Pegelverschiebungsschaltungen durch in dem Halbleitersubstrat (1) eines ersten Leitfähigkeitstyps integrierte Transistoren positiven und negativen Typs ausgebildet ist und einen Signaleingang und einen Signalausgang aufweist, wobei das Halbleitersubstrat an den Substratpegel angeschlossen ist.

15. Halbleiter-Schaltungsanordnung nach Anspruch 14, **dadurch gekennzeichnet, daß** der Steuereingang eines ersten Transistors vom negativen Typ (43) mit dem Signaleingang (40a), mit der einen Elektrode mit einer negativen Versorgungsspannung (40c) und mit der anderen Elektrode mit dem Signalausgang (41) verbunden ist, an dem eine Elektrode eines Transistors vom positiven Typ (44) liegt, dessen andere Elektrode mit einer positiven Versorgungsspannung (40b) und dessen Steuereingang mit dem Signaleingang (40a) verbunden ist, an dem die eine Elektrode eines zweiten Transistors vom negativen Typ (42) liegt, dessen andere Elektrode mit der negativen Versorgungsspannung (40c) und dessen Steuereingang mit dem Signalausgang (41) verbunden ist, und daß die Transistoren vom negativen Typ (42 und 43) innerhalb einer in dem Halbleitersubstrat (1) eingebetteten äu-ßeren Wanne eines zweiten, gegenüber dem ersten Leitfähigkeitstyp entgegengesetzten Leitfähigkeitstyps ausgebildet sind und die äußere Wanne an eine Versorgungsspannung angeschlossen ist.

16. Halbleiter-Schaltungsanordnung nach Anspruch 15, **dadurch gekennzeichnet, daß** vor dem Signaleingang (40a) der Halbleiter-Schaltungsanordnung ein Transistor positiven Typs (45) zwischengeschaltet ist, dessen Steuereingang mit einem Nullpotential verbunden ist und dessen Elektrodenanschlüsse zum einen mit dem Signal (40), und zum anderen mit dem Signaleingang (40a) verbunden sind.

## Claims

1. Semiconductor circuit arrangement having a driver circuit (13) which is integrated in a semiconductor substrate (1) of a first conductance type and comprises a first and a second PV switching transistor (18, 22a) for switching positive and zero-value voltage levels, and a first and a second NV switching transistor (22, 18a) for switching negative and zero-value voltage levels, and an actuation circuit which is positioned upstream of the driver circuit (13) and is likewise formed in the semiconductor substrate (1), with
- the semiconductor substrate (1) being connected to a substrate level,
- the driver circuit (13) comprising a number of circuit stages, and the first stage of the driver circuit having a first inversion and level-changing circuit (17),
- the outputs of the driver circuit (13) being formed by at least one activation line pair, comprising complementary individual lines (20 and 20a),
- the first PV switching transistor (18) being connected between a first line (19) and a first individual line (20),
- the first NV switching transistor (22) being connected between a substrate level and the first individual line (20),
- the second NV switching transistor (18a) being connected between a second line (19a) and a second individual line (20a),
- the second PV switching transistor (22a) being connected between the substrate level and the second individual line (20a), and
- the first PV and the first NV switching transistor (18, 22), connecting the activation voltage, which is present on the first line (18) to the first individual line (20), with the second PV and the second NV switching transistor at the same time connecting the activation voltage which is present on the second line (19a) to the second individual line (20a), or the respective transistors connecting both individual lines (20, 20a) to the substrate level,
wherein
- the NV switching transistors (22, 18a) of the driver circuit (13) are formed within an outer well (10), which is embedded in the semiconductor substrate (1) of a second conductance type, which is the opposite to the first conductance type,
- the outer well (10) is connected to a supply voltage, and
- the two activation voltages can be of opposite polarity.

2. Semiconductor circuit arrangement according to Claim 1, **characterized in that** the actuation circuit is formed by a decoder (15) having a number of outputs (16 and 16a) which are coupled to the driver circuit (13).

3. Semiconductor circuit arrangement according to Claim 2, **characterized in that** an output (16a) of the decoder (15) which is switched to be active supplies a zero level, while all the other outputs of the decoder, which are switched to be passive, each supply a positive potential level.

4. Semiconductor circuit arrangement according to Claim 3, **characterized in that** the first inversion and level-changing circuit (17) is followed by the first PV switching transistor (18) and the second NV switching transistor (18a), which each switch a negative activation voltage (19), which is applied to the driver circuit (13), to at least the first individual line (20) of the activation line pair (20 and 20a), and switch a positive activation voltage (19a), which is likewise applied to the driver circuit, to the second individual line of the at least one activation line pair.

5. Semiconductor circuit arrangement according to Claim 4, **characterized in that** the potential of the positive activation voltage (19) is equal to or greater than the potential of the supply voltage.

6. Semiconductor circuit arrangement according to Claim 5, **characterized in that** the first inversion and level-changing circuit (17) is followed by a second inversion and level-changing circuit (21), which is connected to the control connections of the first NV switching transistor and the second PV switching transistor (22 and 22a), whose electrode connections are connected firstly to the substrate level and secondly to the two complementary individual lines (20 and 20a) of the at least one activation line pair.

7. Semiconductor circuit arrangement according to Claim 6, **characterized in that** the first inversion and level-changing circuit (17) and the first PV switching transistor (18) together with the second NV switching transistor (18a), which switch the positive and negative activation voltage (19 and 19a), each have a protection transistor (23 and 23a) of predefined conductance (NMOS) connected in between them, this control connection is connected to the supply voltage, and whose electrode connections are connected firstly to the first inversion and level-changing circuit and secondly to the first PV switching transistor (18) and to the second NV switching transistor (18a).

8. Semiconductor circuit arrangement according to Claim 7, **characterized in that** a holding transistor (24) is provided, whose control input is connected to the output of the first inversion and level-changing circuit (17), and whose electrode connections are connected firstly to the supply voltage and secondly to the input of the first inversion and level-changing circuit (17).

9. Semiconductor circuit arrangement according to Claim 8, **characterized in that** the holding transistor (24) is formed by an MOS transistor of the positive conductance type.

10. Semiconductor circuit arrangement according to one of Claims 6 to 9, **characterized in that** the first and the second inversion and level-changing circuit (17 and 21), the protection transistors (23 and 23a), the first PV switching transistor (18) together with the second NV switching transistor (18a), and the first NV switching transistor and the second PV switching transistor (22, 22a) are embedded within the outer well (10) in the semiconductor substrate.

11. Semiconductor circuit arrangement according to Claim 10, **characterized in that** the holding transistor (24) is embedded within the outer well.

12. Semiconductor circuit arrangement according to one of Claims 3 to 11, **characterized in that** at least one of the inversion and level-changing circuits is formed by two transistors of opposite polarity (32 and 34), which are integrated in the semiconductor substrate (1) of a first conductance type, and has a signal input (30) and a signal output (31), with the semiconductor substrate (1) being connected to the substrate level.

13. Semiconductor circuit arrangement according to Claim 12, **characterized in that** the control inputs of the transistors are connected to the signal input (30), with the transistor of the positive type (32) being connected by one of its electrodes to a positive supply voltage (33) and by the other electrode to the output (31), and the transistor of the negative type (34) being connected by one of its electrodes to the output (31) and by the other electrode to a negative voltage (35), and **in that** the transistor of the negative type (34) is formed within an outer well, which is embedded in the semiconductor substrate (1), of a second conductance type, which is the opposite of the first conductance type, and the outer well is connected to a supply voltage.

14. Semiconductor circuit arrangement according to one of Claims 3 to 13, **characterized in that** at least one of the inversion and level-changing circuits is formed by transistors of the positive and negative type which are integrated in the semiconductor substrate (1) of a first conductance type, and has a signal input and a signal output, with the semiconductor substrate being connected to the substrate level.

15. Semiconductor circuit arrangement according to Claim 14, **characterized in that** the control input of a first transistor of the negative type (43) is connected to the signal input (40a), one of its electrodes is connected to a negative supply voltage (40c) and its other electrode is connected to the signal output (41) to which one electrode of a transistor of the positive type (44) is connected, and whose other electrode is connected to a positive supply voltage (40b) while its control input is connected to the signal input (40a) to which one of the electrodes of a second transistor of the negative type (42) is connected, whose other electrode is connected to the negative supply voltage (40c) while its control input is connected to the signal output (41), and **in that** the transistors of the negative type (42 and 43) are formed within an outer well, which is embedded in the semiconductor substrate (1), of a second conductance type, which is the opposite to the first conductance type, and the outer well is connected to a supply voltage.

16. Semiconductor circuit arrangement according to Claim 15, **characterized in that** a transistor of the positive type (45) is connected in between upstream of the signal input (40a) of the semiconductor circuit arrangement, its control input is connected to a zero potential, and its electrode connections are connected firstly to the signal (40) and secondly to the signal input (40a).

## Revendications

1. Montage à semi-conducteurs comprenant un circuit (13) d'attaque formé de manière intégrée dans un substrat (1) semi-conducteur d'un premier type de conductivité et constitué d'un premier et d'un deuxième transistors (18, 22a) de commutation PV pour la commutation de niveaux de tension positifs et de valeur nulle et d'un premier et d'un deuxième transistors (22, 18a) de commutation NV pour la commutation de niveaux de tension négatifs et de valeur nulle et un circuit de commande monté en amont du circuit (13) d'attaque et constitué également dans le substrat (1) semi-conducteur, dans lequel :
- le substrat (1) semi-conducteur est relié à un niveau de substrat ;
- le circuit (13) d'attaque est constitué de plusieurs étages de circuit et le premier étage du circuit d'attaque a un circuit (17) d'inversion et de décalage de niveau ;
- les sorties du circuit (13) d'attaque sont formées par au moins une paire de lignes d'activation constituée de lignes (20 et 20a) individuelles complémentaires ;
- le premier transistor (18) de commutation PV est monté entre une première ligne (19) et une première ligne (20) individuelle ;
- le premier transistor (22) de commutation NV est monté entre le niveau de substrat et la première ligne (20) individuelle ;
- le deuxième transistor (18a) de commutation NV est monté entre une deuxième ligne (19a) et une deuxième ligne (20a) individuelle ;
- le deuxième transistor (22a) de commutation PV est monté entre le niveau de substrat et la deuxième ligne (20a) individuelle ;
- le premier transistor (18) de commutation PV et le premier transistor (22) de commutation NV appliquent à la première ligne (20) individuelle la tension d'activation s'appliquant à la première ligne (19), le deuxième transistor de commutation PV et le deuxième transistor de commutation NV appliquant en même temps à la deuxième ligne (20a) individuelle la tension d'activation s'appliquant à la deuxième ligne (19a) ou les transistors respectifs reliant les deux lignes (20, 20a) individuelles au niveau de substrat,
dans lequel
- les transistors (22, 18a) de commutation NV du circuit (13) d'attaque sont constitués à l'intérieur d'un caisson (10) extérieur incorporé dans le substrat (1) semi-conducteur et d'un deuxième type de conductivité opposé au premier type de conductivité ;
- une tension d'alimentation est appliquée au caisson (10) extérieur ; et
- les deux tensions d'activation peuvent être de polarité opposée.

2. Montage à semi-conducteurs suivant la revendication 1, **caractérisé en ce que** le circuit d'attaque est formé d'un décodeur (15) ayant plusieurs sorties (16 et 16a) couplées au circuit (13) d'attaque.

3. Montage à semi-conducteurs suivant la revendication 2, **caractérisé en ce qu'**une sortie (16) du décodeur, qui est montée de manière active, fournit un niveau zéro alors que toutes les autres entrées du décodeur, montées de façon passive, fournissent respectivement un niveau de potentiel positif.

4. Montage à semi-conducteurs suivant la revendication 3, **caractérisé en ce qu'**en aval du premier circuit (17) d'inversion et de décalage de niveau sont montés le premier transistor (18) de commutation PV et le deuxième transistor (18a) de commutation NV qui appliquent, respectivement, une tension (19) d'activation négative s'appliquant au circuit (13) d'attaque à au moins la première ligne (20) individuelle de la paire (20 et 20a) de lignes d'activation et une tension (19a) d'activation positive s'appliquant également au circuit d'attaque à la deuxième ligne individuelle du au moins un couple de lignes d'activation.

5. Montage à semi-conducteurs suivant la revendication 4, **caractérisé en ce que** le potentiel de la tension (19) d'activation positive est égal ou supérieur au potentiel de la tension d'alimentation.

6. Montage à semi-conducteurs suivant la revendication 5, **caractérisé en ce qu'**en aval du circuit (17) d'inversion et de décalage de niveau est monté un deuxième circuit (21) d'inversion et de décalage de niveau, qui est relié aux bornes de commande du premier transistor (22) de commutation NV et du deuxième transistor (22a) de commutation PV, dont les bornes d'électrode sont reliées d'une part au niveau de substrat et d'autre part aux deux lignes (20 et 20a) individuelles complémentaires du au moins un couple de lignes d'activation.

7. Montage à semi-conducteurs suivant la revendication 6, **caractérisé en ce qu'**il est monté entre le premier circuit (17) d'inversion et de décalage de niveau et le premier transistor (18) de commutation PV ainsi que le deuxième transistor (18a) de commutation NV qui applique la tension (19 et 19a) d'activation positive et négative, respectivement, un transistor (23 et 23a) de sécurité de conductivité (NMOS) définie à l'avance, qui est relié par sa borne de commande à la tension d'alimentation et par ses bornes d'électrode d'une part au premier circuit d'inversion et de décalage de niveau et d'autre part au premier transistor (18) de commutation PV et au deuxième transistor (18a) de commutation NV.

8. Montage à semi-conducteurs suivant la revendication 7, **caractérisé en ce qu'**il y a un transistor (24) de maintien qui est relié par son entrée de commande à la sortie du premier circuit (17) d'inversion et de décalage de niveau et par ses bornes d'électrode d'une part à la tension d'alimentation et d'autre part à l'entrée du premier circuit (17) d'inversion et de décalage de niveau.

9. Montage à semi-conducteurs suivant la revendication 8, **caractérisé en ce que** le transistor (24) de maintien est formé par un transistor MOS de type de conduction positif.

10. Montage à semi-conducteurs suivant l'une des revendications 6 à 9, **caractérisé en ce que** le premier et le deuxième circuit (17 et 21) d'inversion et de décalage de niveau, les transistors (23 et 23a) de sécurité, le premier transistor (18) de commutation PV ainsi que le deuxième transistor (18a) de commutation NV et le premier transistor (22) de commutation NV et le deuxième transistor (22a) de commutation PV sont incorporés à l'intérieur du caisson (10) extérieur du substrat semi-conducteur.

11. Montage à semi-conducteurs suivant la revendication 10, **caractérisé en ce que** le transistor (24) de maintien est incorporé à l'intérieur du caisson extérieur.

12. Montage à semi-conducteurs suivant l'une des revendications 3 à 11, **caractérisé en ce qu'**au moins l'un des circuits d'inversion et de décalage de niveau est formé par deux transistors (32 et 34) de polarité opposée intégrés dans le substrat (1) semi-conducteur d'un premier type de conductivité et a une entrée (30) de signal et une sortie (31) de signal, le substrat (1) semi-conducteur étant relié au niveau de substrat.

13. Montage à semi-conducteurs suivant la revendication 12, **caractérisé en ce que** les entrées de commande des transistors sont reliées à l'entrée (30) de signal, le transistor de type (32) positif étant relié par l'une de ses électrodes à une tension (33) d'alimentation positive et par son autre électrode à la sortie (31) et le transistor de type (34) négatif étant relié par l'une des électrodes à la sortie (31) et par l'autre électrode à une tension (35) négative et **en ce que** le transistor de type (34) négatif est formé à l'intérieur d'un caisson extérieur incorporé dans le substrat (1) semi-conducteur et d'un deuxième type de conductivité opposé au premier type de conductivité et une tension d'alimentation s'applique au caisson extérieur.

14. Montage à semi-conducteurs suivant l'une des revendications 3 à 13, **caractérisé en ce qu'**au moins l'un des circuits d'inversion et de décalage de niveau est formé par des transistors de type positif et négatif intégrés dans le substrat (1) semi-conducteur d'un premier type de conductivité et a une entrée de signal et une sortie de signal, le substrat semi-conducteur étant relié au niveau de substrat.

15. Montage à semi-conducteurs suivant la revendication 14, **caractérisé en ce que** l'entrée de commande d'un premier transistor de type (43) négatif ayant l'entrée (40a) de signal est relié par l'une de ses électrodes à une tension (40c) d'alimentation négative et par l'autre de ses électrodes à la sortie (41) de signal à laquelle s'applique une électrode d'un transistor de type (44) positif dont l'autre électrode est reliée à une tension (40b) d'alimentation positive et dont l'entrée de commande est reliée à l'entrée (40a) de signal à laquelle s'applique l'électrode d'un deuxième transistor de type (42) négatif dont l'autre électrode est reliée à la tension (40c) d'alimentation négative et dont l'entrée de commande est reliée à la sortie (41) de signal et **en ce que** les transistors de type (42 et 43) négatif sont formés à l'intérieur d'un caisson extérieur incorporé dans le substrat (1) semi-conducteur et d'un deuxième type de conductivité opposé au premier type de conductivité et une tension d'alimentation est appliquée au caisson extérieur.

16. Montage à semi-conducteurs suivant la revendication 15, **caractérisé en ce qu'**il est monté intermédiairement avant l'entrée (40a) du signal du montage à semi-conducteur un transistor de type (45) positif, dont l'entrée de commande est reliée à un potentiel zéro et dont les bornes d'électrode sont reliées d'une part au signal (40) et d'autre part à l'entrée (40a) du signal.
